Europäisches Patentamt

European Patent Office

Office européen des brevets

(11) Veröffentlichungsnummer: **0 054 938**
**A1**

# (12) EUROPÄISCHE PATENTANMELDUNG

(21) Anmeldenummer: 81110599.8

(22) Anmeldetag: 18.12.81

(51) Int. Cl.³: **H 03 F 1/02, H 03 F 3/30**

(30) Priorität: 23.12.80 DE 3048648

(43) Veröffentlichungstag der Anmeldung: 30.06.82
Patentblatt 82/26

(84) Benannte Vertragsstaaten: **CH DE FR GB IT LI NL SE**

(71) Anmelder: **Gulczynski, Zdzislaw,
Rosenheimerstrasse 30, D-8000 München 80 (DE)**

(72) Erfinder: **Gulczynski, Zdzislaw, Rosenheimerstrasse 30,
D-8000 München 80 (DE)**

(74) Vertreter: **Lewald, Dietrich, Dipl.-Ing., Birnauer
Strasse 6, D-8000 München 40 (DE)**

(54) **Leistungsverstärker mit Ruhestromregler.**

(57) Der Ruhestrom oder die Ruheströme von den End-transistoren in der Gegentaktendstufe (T) werden bei einer bestimmten Ausgangsspannung und/oder in einem bestimmten Ausgangsspannungsbereich des Verstärkers abgetastet, in mehreren Komparatoren (K) werden ihre Werte kodiert und in einem und/oder mehreren analogen und digitalen Speicherelementen (S) die entsprechenden Werte gespeichert. Der gewünschte Ruhestrom wird über die steuerbare Stromquelle (Q) eingestellt.

EP 0 054 938 A1

PATENTANWALT

ZUGEL. VERTRETER B. EUROP. PATENTAMT
PROFESSIONAL REPRESENTATIVE BEFORE EPO
MANDATAIRE AGREÉ PRÉS 1' OEB

BIRNAUER STRASSE 6
TELEFON (0 89) 30 65 14
Cable address: LEWALDPAT

DIPL.-ING. DIETRICH LEWALD · BIRNAUER STR. 6 · 8000 MÜNCHEN 40

0054938

Zdzislaw GULCZYNSKI
Rosenheimerstr. 30
D-8000 München 80

## Leistungsverstärker mit Ruhestromregler

Die Erfindung betrifft einen Gegentakt-Leistungsverstärker mit Ruhestromregler, insbesondere für Niederfrequenz-Leistungsverstärker hoher Qualität.

Um eine lineare Arbeitsart der Endtransistoren eines Leistungsverstärkers von sehr schwachen Ausgangssignalen bis zur Vollaussteuerung gewährleisten zu können, muß ein Arbeitspunkt bestimmt werden. Das Hauptproblem einer Gegentakt-Endstufe besteht darin, den gewünschten Ruhestrom über einen großen Temperaturbereich konstant zu halten.

Bei den herkömmlichen Leistungsverstärkern wird im Arbeitspunktregler ein Bauelement verwendet, das mit Ausgangstransistoren thermisch verbunden ist. Die thermischen Änderungen eines elektrischen Wertes des Bauelements werden zur Kompensation der Änderungen des Ruhestroms der Endstufe benützt.

POSTSCHECKKONTO MÜNCHEN 1990 20-800 · BAYERISCHE HYPOTHEKEN- UND WECHSEL-BANK MÜNCHEN 3 240 000 880

0054938

Eine andere Methode ist die direkte Erfassung des Ruhestroms. Sein Meßwert wird an einem, in Serie mit Endtransistoren gelegten Widerstand abgenommen. Der Widerstand wird durch eine Diode überbrückt, damit der Spannungsabfall im Aussteuerungsbetrieb nicht zu hoch ist. Als Meßwert wird ein Mittelwert der Spannung an dem Widerstand angenommen, der im Aussteuerungsbetrieb annähernd unverändert bleibt.

Bei der Verwendung von Feldeffekt-Transistoren für Leistungsverstärkung wird ihre Eigenschaft ausgenützt, daß bei einer bestimmten Gate-Source-Spannung $U_{GSO}$ ihr Drain-Strom unabhängig von der Temperatur ist. Diese Spannung wird konstant festgehalten.

In Pulse-Width-Modulation (PWM) Leistungsverstärkern wird das NF-Eingangssignal in eine digitale Form umgewandelt, verarbeitet und nach einer Rückwandlung als ein verstärktes Signal am Ausgang erzeugt.

In der ersten Methode muß der Ruhestrom, wegen der Streuungen an den Parametern, der im Verstärker verwendeten Halbleiter, von Hand eingestellt werden. Das ist sehr zeitraubend. Sehr nachteilig ist auch die gegenüber Festwiderständen geringe Langzeitstabilität des Einstellwiderstandes. Die Trägheit der Reaktion bei Temperaturerhöhungen in den Transistorkristallen der Endtransistoren wird durch schlechte thermische Kopplung mit dem Fühlerelement verursacht. Die zusätzlichen Stabilisierungsmaßnahmen, die durch in Reihe mit der angeschlossenen Last liegenden Widerstände erreicht werden, setzen die erhältliche Ausgangsleistung herunter.

Die zweite Methode, obwohl sie die oben genannten Nachteile vermeidet, verbessert im Endeffekt kaum die Stabilität des Ruhestroms. Die Einflüsse von Umgebungstemperatur, Betriebsspannung, Exemplarstreuungen der verwendeten Halbleiter, Amplitude und Kurvenform des Ausgangssignales sind nicht zu vernachlässigen.

Bei der dritten Methode wird bereits von Halbleiter-Hersteller der Ruhestrom bestimmt, der nur aus dem Ansichtspunkt der Temperaturunabhängigkeit optimal ist. Außerdem ist es praktisch unmöglich, daß die $U_{GSO}$ Spannung von den beiden, komplementären Endtransistoren gleich ist. Auch bei verschiedenen Exemplaren von den selben Typen der Transistoren ist die Spannung unterschiedlich.

PWM-Verstärker fordern einen riesigen, technologischen Aufwand und sind sehr kostspielig. Ein für die Rückwandlung des digitalen PWM-Signals eingesetztes LC-Filternetzwerk erhöht die Ausgangsimpedanz des Verstärkers beträchtlich. Sehr kritisch sind sowohl Störstrahlungen, die bis in die Rundfunk- und Fernseh-Empfangsbereiche reichen, als auch klangverzerrende Intermodulation zwischen der Schaltfrequenz und den Signalfrequenzen.

Der Erfindung liegt die Aufgabe zugrunde, den Ruhestrom der Endtransistoren wegen der Exemplarstreuungen der im Verstärker verwendeten Halbleiter, Temperatur-, Betriebsspannungen usw. mit hoher, gegenüber den bekannten Schaltungen erhöhter Genauigkeit festzuhalten.

- 4 -

0054938

Diese Aufgabe wird erfindungsgemäß dadurch gelöst, daß der Ruhestrom oder die Ruheströme von den Endtransistoren bei einer bestimmten Ausgangsspannung und/oder- in einem bestimmten Ausgangsspannungsbereich des Verstärkers abgetastet, in mehreren Komparatoren ihre Werte kodiert und in einem und/ oder mehreren analogen und digitalen Speicherlementen die entsprechenden Werte, die die gewünschten. Werte des Ruhestroms oder der Ruheströme nachregeln bzw. in einem gewünschten Bereich halten lassen, gespeichert werden.

Es wurden damit mehrere, sehr wertvolle Vorteile erreicht:

a) Keine thermische Rückkopplung mit den Endtransistoren erforderlich.
b) Keine Einstellungen erforderlich.
c) Geringe Anzahl von Bauteilen.
d) Sehr hohe Genauigkeit der Stabilisierung (gegen Betriebsspannungs-, Temperaturänderungen usw.).
e) Beim Einschalten des Verstärkers fließt kein Ruhestrom und die Ausgangstransistoren werden nicht ausgesteuert. Bei den herkömmlichen Verstärkern fließt dabei oft ein Kurzschlußstrom.
f) Einfache Integrationsmöglichkeit der Steuerstufe.
g) Einfache Realisierung einer Kurzschlußsicherung.
h) Möglichkeiten einer digitalen Verarbeitung des Ruhestroms z.B. digitale Speicherung eines entsprechenden Meßwertes, Änderung des Ruhestroms je nach Größe des Ausgangsignals, Warnungssignalisation vor Überhitzung der Endtransistoren usw.

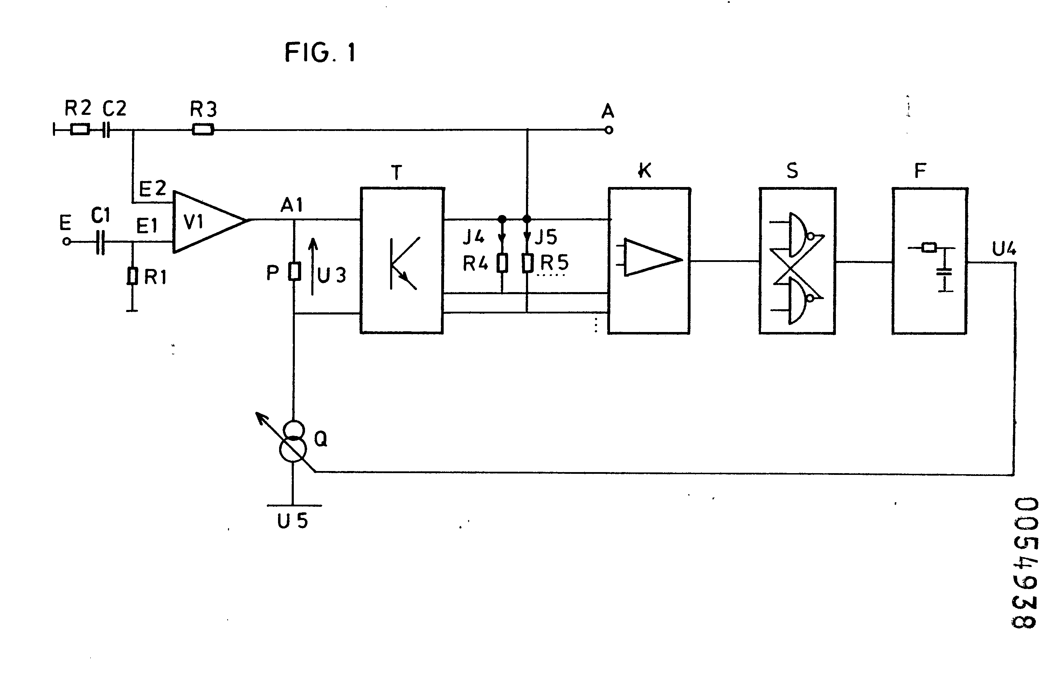

In Fig. 1 ist der erfindungsgemäße Leistungsverstärker dargestellt.

0054938

Der Leistungsverstärker besteht im wesentlichen aus einem Operationsverstärker V1 und einer Transistorstufe T. Das an einem Eingang E des Leistungsverstärkers angelegte Signal wird über ein RC-Glied R1, C1 einem ersten Eingang E1 des Operationsverstärkers V1 zugeführt. Ein zweiter Eingang E2 ist über einen Spannungsteiler R2, R3, C2 mit dem eigentlichen Ausgang A des Leistungsverstärkers verbunden.

Der Operationsverstärker steuert die Transistorstufe T, die aus zwei im Gegentakt geschalteten Leistungstransistoren besteht. Im Falle einer nicht ausreichenden Spannungs- bzw. Leistungsverstärkung kann sie um Treibertransistoren erweitert werden; als Endtransistoren können Leistungstransistorpakete eingesetzt werden. An den Ausgang A1 des Operationsverstärkers V1 ist auch ein Zweipol P angeschlossen, der im einfachsten Fall aus einem Widerstand besteht. An diesem Zweipol liegt eine Steuerspannung U3, die hauptsächlich von einer steuerbaren Stromquelle Q beeinflußt wird.

Die Steuerspannung U3 enthält eine Information über Temperaturen der im Transistorteil T verwendeten Transistoren. Diese Spannung kann abgetastet werden, z.B. durch Aufbau einer zusätzlichen steuerbaren Stromquelle, die genau den gleichen Strom liefert wie die Stromquelle Q und deren Ausgang über einen Widerstand mit einer festen Spannung versorgt wird. Es kann auch zwischen die Stromquelle Q und die Spannungsquelle U5 ein Widerstand angeschlossen werden.

Wird die Spannung an den Widerstand bzw. ein in einem temperaturabhängigen Spannungsteiler erzeugter Teil dieser Spannung, der die Temperaturänderungen von bestimmten Transistoren berücksichtigt, verstärkt oder pegelabhängig kodiert, kann eine Temperatur oder eine bestimmte Temperatur eines oder mehrerer in der Transistorstufe T arbeitenden Transistoren bestimmt bzw. geschätzt und eventuell angezeigt werden.

Die Transistorstufe T besitzt mehrere (mindestens zwei) Ausgänge. Einer von diesen ist der Ausgang A des gesamten Verstärkers. Die anderen Ausgänge sind mit dem Ausgang A über Widerstände R4, R5 usw. verbunden. Sie können durch Dioden oder Transistoren überbrückt werden. Die durch die Widerstände fließenden Ausgangsströme J4, J5 usw. von den Endtransistoren der Transistorstufe T werden bei einer bestimmten Ausgangsspannung und/oder in einem bestimmten Ausgangsspannungsbereich in einem Komparatorenteil K abgetastet und ihre Werte kodiert. Es wird dadurch festgestellt, ob die Ruheströme zu hoch oder zu niedrig sind. Diese Werte, mit denen die gewünschten Werte der Ruheströme nachgeregelt werden können, werden gespeichert, und zwar auf zwei verschiedene Arten, zuerst in einem digitalen Speicher S, der aus einem oder mehreren Flip-Flops besteht (digitale Speicherung) und dann in einem Speicher F mit Tiefpaß-Eigenschaften, der aus einem oder mehreren RC-Gliedern und evtl. Pegelumsetzern besteht (analoge Speicherung).

Die am Ausgang des Speichers F verfügbare analoge Spannung U4 steuert die Stromquelle Q, die mit einer festen Spannung U5 versorgt wird. Die Ruheströme können auch zusätzlich durch eine thermische Rückkopplung beeinflußt werden. Dann muß ein Teil vom Zweipol P thermisch mit den Endtransistoren gekoppelt werden. Besitzt die Transistorstufe T mehrere Eingänge, dann werden mehrere analoge Spannungen U4 zur Verfügung gestellt, die mehrere steuerbare Stromquellen Q steuern, an denen mehrere Zweipole P angeschlossen sind. Die Zweipole sind jedoch immer an den Ausgang A1 des Operationsverstärkers V1 angeschlossen.

0054938

Im digitalen Speicher kann auch ein Zähler arbeiten, dessen Inhalt der Steuerspannung U3 entspricht. Der Ruhestrom wird dadurch nachgeregelt, daß sein .Inhalt verringert oder vergrößert wird. Die Erzeugung des Steuersignals für den Speicher F erfolgt auf übliche Weise, z.B. durch Verwendung eines DA-Wandlers oder der PWM-Methode. Es kann auch ein Schieberegister verwendet werden, dessen einzelne Bits stets geschoben werden. Die an seinem Ausgang erscheinenden Bits werden verändert an seinem Eingang übertragen, solange durch die Änderung des Registerinhalts die Ruheströme nachgeregelt werden.

Die Werte der Ruheströme können nach dem Ausgangsspannungspegel dadurch geändert werden, daß die entsprechenden Referenzspannungen von den Komparatoren des Teils K nach dem Ausgangsspannungspegel des Leistungsverstärkers bestimmt werden. Ein Komparator kann im einfachsten Fall bereits mit einem einzigen Transistor ausgeführt werden. Seine Referenzspannung wird dann festgelegt als Basis-Emitter-Spannung des Transistors.

Falls der Leistungsverstärker in einer Brückenschaltung ausgeführt ist, sind zwei wie in Fig. 1 dargestellte Leistungsverstärker nötig.

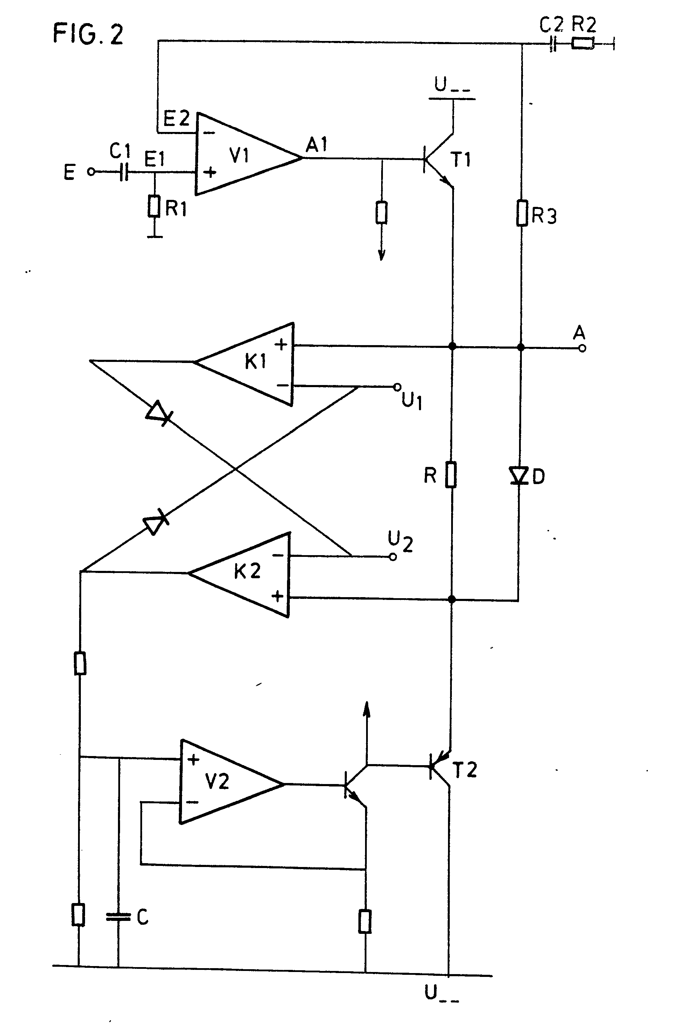

Fig. 2 zeigt ein einfachstes Ausführungsbeispiel.

Es sei zunächst angenommen, daß die eingangsnullspannungen (Offset-Spannungen) von Operationsverstärker V1 und Komparatoren K1 und K2 gleich Null sind.

Die Abtastung und Digitalisierung des Ruhestroms erfolgt in den beiden Komparatoren K1 und K2. Im Ruhezustand, also auch bei Null der Eingangsspannung beträgt die Ausgangsspannung ebenfalls Null. Da die Referenzspannung $U_1$ größer ist als Null, beträgt die Ausgangsspannung von K1 $U_{--}$ (negative Betriebsspannung). Der Ruhestrom fließt durch den Widerstand R. Der Einfluß der Diode D ist dann zu vernachlässigen.

Die Spannung an R wird mit der Referenzspannung $U_2$ im K2 verglichen, die negativ ist und den Wert des Ruhestroms bestimmt.

Ist der Ruhestrom zu gering, beträgt die Ausgangsspannung von K2 $U_{++}$. Der Kondensator C wird aufgeladen. Ist der Ruhestrom zu groß, beträgt die Ausgangsspannung $U_{--}$. Der Kondensator C wird entladen.

Der Operationsverstärker V2 und der angeschlossene Transistor bilden sogenannte Präzisionsstromquellen. Wächst die Spannung auf C, wird der Ruhestrom größer.

Steigt die Ausgangsspannung von Null über $U_1$ und ist der Ruhestrom zu gering, wird der Komparator K1 gesperrt. C wird aufgeladen. Ist der Ruhestrom zu groß, wird K2 von K1 gesperrt. C wird entladen. Liegt die Ausgangsspannung unter $U_1$, wird C immer entladen.

Abtastung des Ruhestromwertes erfolgt also bei $U_1$ der Ausgangsspannung. Ist der Ruhestrom zu gering, wird der Kondensator C während einer positiven Halbwelle aufgeladen.
Ist er zu groß, wird C während der ganzen Periode des Eingangssignals entladen.

Der Komparatorenteil K1 und K2 ist mit dem Speicher S in einen Funktionsblock gefaßt.

Bestimmung der Referenzspannungen:

$$U_1 = U_{OSV1} + U_{OSK1} + U_0$$

$$U_2 = -RJ_0 + U_1 - U_0 + U_{OSK2} - U_{OSK1}$$

wobei

$U_1$, $U_2$ - Referenzspannungen von K1, K2

$U_{OSV1}$, $U_{OSK1}$, $U_{OSK2}$ - Offset Spannungen von V1,K1,K2

$J_0$ - Ruhestrom

$U_0$ - eine Spannung, damit $U_1$ immer größer ist als Null.

Die Basen der Endtransistoren sind über einen Widerstand miteinander verbunden.

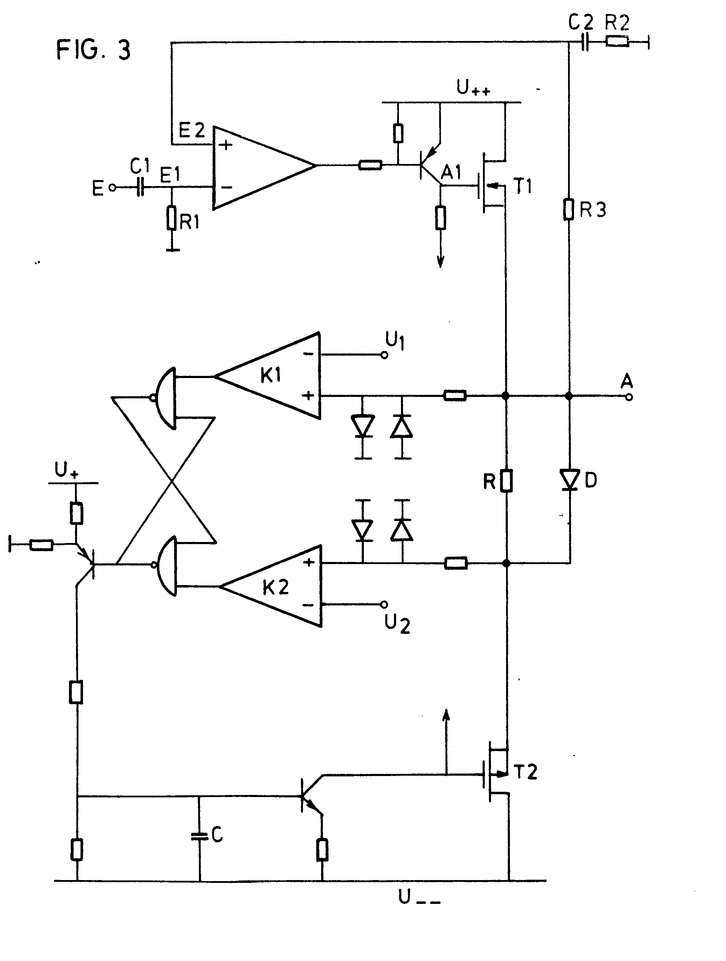

Ein anderes Ausführungsbeispiel des Verstärkers stellt Fig. 3 dar.

In dem Modell wurde ein Baustein verwendet, der zwei Komparatoren und zwei NAND-Gatter enthält. Es wird von seinen eigenen Betriebsspannungen $U_+$ und $U_-$ versorgt. Als Endtransistoren T1, T2 können beliebig Darlington- oder MOSFET-Leistungstransistoren verwendet werden.

Fig. 4 zeigt ein Ausführungsbeispiel, in dem die Diode D durch einen steuerbaren Transistor ersetzt wurde. Dadurch kann die Meßspannung an dem Widerstand R vergrößert und eventuell (z.B. je nach dem Ausgangssignalpegel) reguliert werden.

Fig. 5 stellt ein Ausführungsbeispiel einer Kurzschlußsicherung dar. Ist der Ausgangsstrom zu groß, wird an dem
Widerstand R6 eine Spannung erreicht, die den Transistor
T3 oder T4 sättigt. Es wird dadurch eine entsprechende
Basis-Emitter-Spannung von dem Transistor T1 oder T2
verringert. Der Ausgangsstrom wird verringert. Wird mit
der Last ein Widerstand angeschlossen, kann die Begrenzung
des Ausgangsstroms nach dem gleichen Prinzip erfolgen.

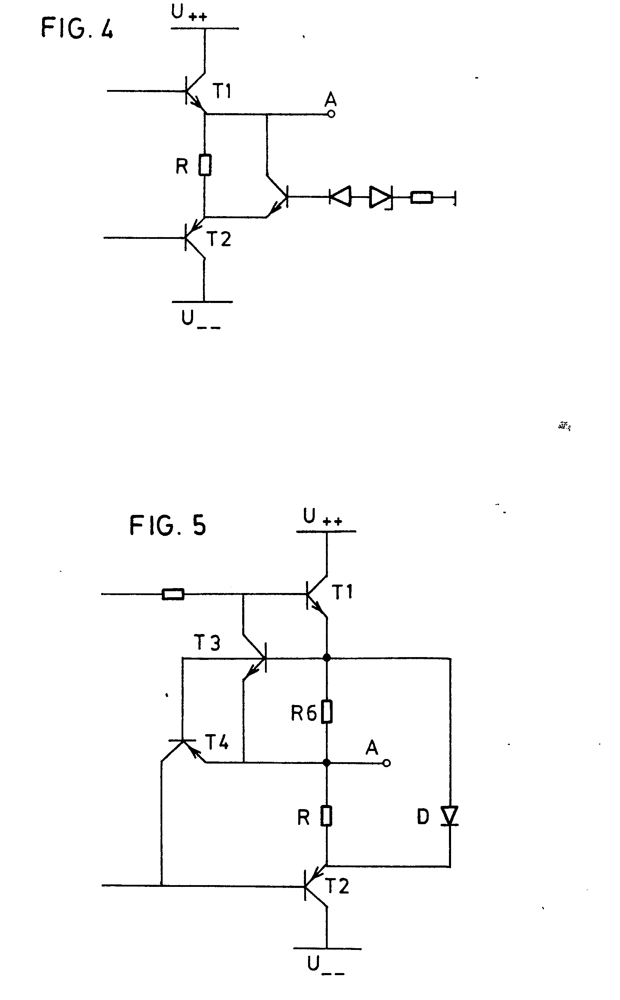

Die Figuren 4 und 5 zeigen in vereinfachter Form einen
Ausschnitt aus dem Schaltbild gemäß Fig. 1. Der Regelkreis zur Ruhestromregelung wurde aus Gründen einfacher
Darstellung weggelassen. Er kann aus Fig. 2 oder Fig. 3
ergänzt werden.

0054938

Patentansprüche

1. Leistungsverstärker mit Gegentaktendstufe und Ruhestromregler, dadurch gekennzeichnet, daß der Ruhestrom oder die Ruheströme von den Endtransistoren bei einer bestimmten Ausgangsspannung und/oder in einem bestimmten Ausgangsspannungsbereich des Verstärkers abgetastet, in mehreren Komparatoren ihre Werte kodiert und in einem und/oder mehreren analogen und digitalen Speicherelementen die entsprechenden Werte, die die gewünschten Werte des Ruhestroms oder der Ruheströme nachregeln bzw. in einem gewünschten Bereich halten lassen, gespeichert werden.

2. Leistungsverstärker nach Anspruch 1, dadurch gekennzeichnet, daß der Verstärker in Brückenschaltung ausgeführt ist.

3. Leistungsverstärker nach Anspruch 1, dadurch gekennzeichnet, daß eine oder mehrere Steuerspannungen oder -ströme der im Verstärker arbeitenden eines oder mehrerer Transistoren abgetastet werden, wodurch die Temperatur oder eine bestimmte Temperatur eines oder mehrerer Endtransistoren des Verstärkers bestimmt bzw. geschätzt und eventuell angezeigt wird.

4. Leistungsverstärker nach Anspruch 1, dadurch gekennzeichnet, daß der Überlastungs- bzw. Kurzschlußstrom an einem oder mehreren in Serie mit den Endtransistoren oder mit der Last angeschlossenen Widerständen abgetastet wird.

0054938

5. Leistungsverstärker nach Anspruch 1, dadurch gekennzeichnet, daß der Wert des Ruhestroms oder die Werte der Ruheströme nach dem Ausgangsspannungspegel des Verstärkers bestimmt werden.

6. Leistungsverstärker nach Anspruch 1, dadurch gekennzeichnet, daß der Ruhestrom oder die -ströme zusätzlich durch eine thermische Rückkopplung mit den Endtransistoren beeinflußt werden.

7. Leistungsverstärker nach Anspruch 1, dadurch gekennzeichnet, daß der Widerstand oder die Widerstände, an denen der Ruhestrom oder die Ruheströme abgetastet werden, durch Dioden und/oder steuerbare Transistoren überbrückt werden.

8. Leistungsverstärker mit Gegentaktendstufe und Ruhestromregler, dadurch gekennzeichnet, daß in Hintereinanderschaltung ein Operationsverstärker und ein Leistungsverstärker vorgesehen sind, dessen Ausgänge zu Komparatoren geführt sind, wobei das Komparatorergebnis in aufeinanderfolgende digitale und analoge Speicher eingespeichert wird, und die Ausgänge des analogen Speichers steuerbare Stromquellen beeinflussen, die die Ruheströme des Leistungsverstärkers bestimmen, wobei bei zu hohen Ruheströmen diese verringert und bei zu niedrigen diese erhöht werden.

FIG. 1

0054938

FIG. 2

FIG. 3

3/4

0054938

**FIG. 4**

**FIG. 5**

**Europäisches Patentamt**

## EUROPÄISCHER RECHERCHENBERICHT

EP 81 11 0599.8

| | EINSCHLÄGIGE DOKUMENTE | | | KLASSIFIKATION DER ANMELDUNG (Int. Cl.³) |
|---|---|---|---|---|
| Kategorie | Kennzeichnung des Dokuments mit Angabe, soweit erforderlich, der maßgeblichen Teile | | betrifft Anspruch | |
| X | DE – B – 1 288 148 (TELEFUNKEN PATENT-VERWERTUNG)<br>* Fig. 1 * | | 1,3 | H 03 F  1/02<br>H 03 F  3/30 |
| X | US – A – 3 886 466 (C.F. WHEATLEY)<br>* Fig. 3 * | | 2 | |
| Y | DE – A1 – 2 438 276 (INTERNATIONAL BU-SINESS MACHINES)<br>* Fig. 5 , Position 50 * | | 4 | |
| Y | DE – B2 – 2 137 249 (DEUTSCHE AUTOMO-BILGESELLSCHAFT)<br>* Fig. 1 * | | 5 | RECHERCHIERTE SACHGEBIETE (Int. Cl.³)<br><br>H 03 F  1/02<br>H 03 F  1/52<br>H 03 F  3/20 |
| Y | DE – A1 – 2 445 738 (THOMSON-CSF)<br>* Anspruch 1 * | | 6 | H 03 F  3/26<br>H 03 F  3/30 |
| Y | Patent Abstracts of Japan<br>Band 5, Nr. 11, 23. Januar 1981<br>Seite 683E42<br>& JP – A – 55 – 138905 | | 5 | |
| A | DE – C3 – 2 424 812 (RCA)<br>* Fig. 1 * | | | |
| A | GB – A – 2 053 609 (UNISEARCH)<br>* Fig. 2 *<br>./.. | | | |

**KATEGORIE DER GENANNTEN DOKUMENTE**

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsätze
E: älteres Patentdokument, das jedoch erst am oder nach dem Anmeldedatum veröffentlicht worden ist
D: in der Anmeldung angeführtes Dokument
L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Berlin | 24-02-1982 | BREUSING |

EPA form 1503.1  06.78

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| A | GB - A - 2 073 524 (TELEFONAKTIEBOLAGET LM ERICSSON) <br> * Fig. 1 * <br><br> -- | |
| A | Patent Abstracts of Japan <br> Band 3, Nr. 2, 13. Januar 1979 <br> Seite 54E83 <br> & JP - A - 53 - 129569 <br><br> ---- | |

**KLASSIFIKATION DER ANMELDUNG** (Int. Cl.3) ·

**RECHERCHIERTE SACHGEBIETE** (Int. Cl.3)

EPA Form 1503.2 06.78